# EUROPÄISCHE PATENTSCHRIFT

(11) **EP 1 284 011 B1**
(45) Veröffentlichungstag und Bekanntmachung des Hinweises auf die Patenterteilung: **09.11.2005**
(21) Anmeldenummer: 01931619.9
(22) Anmeldetag: 18.04.2001
(51) Int. Cl.: H01L 21/00

(54) **VORRICHTUNG UND VERFAHREN ZUM BEHANDELN, LAGERN UND BESCHICKEN VON TRÄGERN FÜR SCHEIBENFÖRMIGE GEGENSTÄNDE**
DEVICE AND METHOD FOR TREATING, STORING AND LOADING SUPPORTS FOR DISK-SHAPED ARTICLES
DISPOSITIF ET PROCEDE POUR TRAITER, STOCKER ET EQUIPER DES SUPPORTS POUR OBJETS EN FORME DE DISQUE

(30) Priorität: 16.05.2000 EP 00110455
(43) Veröffentlichungstag der Anmeldung: 19.02.2003
(73) Patentinhaber: Infineon Technologies SC300 GmbH & Co. KG, 01099 Dresden (DE)
(72) Erfinder: LERING, Michael, 91088 Bubenreuth (DE); MISSALE, Reiner, 93155 Hemau (DE); PEITER, Martin, 01097 Dresden (DE)
(74) Vertreter: Epping - Hermann - Fischer
(86) Internationale Anmeldenummer: PCT/EP2001/004413
(87) Internationale Veröffentlichungsnummer: WO 2001/088963

(56) Entgegenhaltungen:
- EP-A- 0 335 752
- WO-A-00/22653
- WO-A-99/18603
- US-A- 5 972 727
- "SORTING AND TRANSFER DRIVE MECHANISM" IBM TECHNICAL DISCLOSURE BULLETIN,US,IBM CORP. NEW YORK, Bd. 33, Nr. 6A, 1. November 1990 (1990-11-01), Seiten 134-143, XP000107661 ISSN: 0018-8689

## Beschreibung

Die vorliegende Erfindung betrifft eine Vorrichtung und ein Verfahren zum Behandeln, Lagern und Beschicken von Trägern für scheibenförmige Gegenstände, wie Halbleiterscheiben oder CDs.

In der Halbleiterindustrie werden bei der Herstellung und Bearbeitung von Halbleiterscheiben, z.B. aus Silizium, (im folgenden auch als Wafer bezeichnet, die ebenfalls auch "Substrates" genannt werden), die Halbleiterscheiben einer Vielzahl von Bearbeitungsschritten unterzogen. Diese Verfahrensschritte werden meist in örtlich getrennten Prozeßmaschinen ausgeführt. Aufgrund der unterschiedlichen Bearbeitungszeiten in den einzelnen Prozeßmaschinen ist es daher notwendig die Wafer an geeigneter Stelle zu sammeln um den einzelnen Bearbeitungseinheiten ständig Wafer zuführen zu können. Weiterhin müssen die Wafer zwischen den einzelnen Vorrichtungen transportiert werden.

Für die Aufbewahrung und den Transport werden in der Halbleitertechnik in der Regel Träger eingesetzt, die mehrere Wafer aufnehmen können und von denen die Wafer einzeln entnommen werden können. Die Träger weisen üblicherweise die Form eines Magazins (auch "Cassette" genannt) auf, in dem die Wafer horizontal gelagert sind. Vorzugsweise wird der Träger in einer Box (auch "Pod" genannt) gehalten, die an ihrer Vorderseite eine Tür aufweist. Eine solche Box wird z.B. in SEMI Standard E47.1 beschrieben. Diese Boxen werden als Front Opening Unified Pod (FOUP) bezeichnet. Bei den einzelnen Bearbeitungsschritten können aufgrund der mechanischen oder chemischen Bearbeitung Verunreinigungen auftreten, die sich auch in den Trägern ansammeln können.

Insbesondere auf dem Gebiet der Halbleitertechnik ist die Reinigung von Trägern und Behältern, in denen die Wafer von einer Bearbeitungsstation zur nächsten transportiert werden, bzw. in denen sie zwischengelagert werden, von Bedeutung, da die Reinheit der Träger und Behälter auf die Reinheit der Waferoberflächen und damit auf die zu erzielende Waferqualität Einfluß hat. Es soll die geringst mögliche partikuläre und molekulare Kontamination erreicht werden.

Insbesondere bei sogenanntem work-in-progress (WIP) Material, bei dem die Bearbeitung bereits begonnen hat aber noch nicht abgeschlossen ist, ist die Einhaltung von Reinheitserfordernissen von besonderer Bedeutung.

Neben diesem Erfordernis der Reinheit der Wafer und Waferträger liegen in der Halbleiterindustrie die Bestrebungen darin, die Kosten pro behandeltem Wafer zu reduzieren. Um dieses Ziel zu erlangen, müssen der Durchsatz einer Bearbeitungsanlage erhöht und die Anlagenkosten reduziert werden. Der Durchsatz wird wesentlich durch die Behandlungsdauer beeinflußt. Neben der tatsächlichen Behandlungsdauer der Wafer treten aber auch Zeiten der Unproduktivität auf, in denen der Wafer keiner Behandlung unterzogen wird, sondern lediglich für den nächsten Behandlungsschritt bereit liegt, oder in denen die Wafer von einer Bearbeitungsanlage zur nächsten transportiert werden.

Aufgabe der vorliegenden Erfindung ist es, eine Vorrichtung und ein Verfahren zum Behandeln, Lagern und Beschicken von Trägern für scheibenförmige Gegenstände, wie Halbleiterscheiben oder CDs bereitzustellen, mit der/dem der Durchsatz einer Bearbeitungsanlage für scheibenförmige Gegenstände erhöht und insbesondere eine hohe Produktivität ermöglicht werden. Weiterhin soll die Vorrichtung einfach und zuverlässig zu bedienen sein.

Der Erfindung liegt der Gedanke zugrunde, daß diese Aufgabe durch eine Vorrichtung und ein Verfahren gelöst werden kann, mit denen eine dezentrale.Lagerung und Reinigung von benötigtem Hilfsmaterial ermöglicht wird und ideal in den Materialfluß der zu behandelnden Gegenstände eingegliedert wird.

Die Aufgabe wird erfindungsgemäß gelöst durch eine Vorrichtung zum Behandeln, Lagern und Beschicken von Trägern für scheibenförmige Gegenstände, wie Halbleiterscheiben oder CDs, die mindestens eine Reinigungseinheit und mindestens einen Speicher für die Träger, sowie mindestens eine Sortiereinheit für die scheibenförmigen Gegenstände umfaßt, wobei die Reinigungseinheit, der Speicher und die Sortiereinheit integrale Bestandteile der Vorrichtung sind und durch eine gemeinsame Regelung betrieben werden.

Im folgenden wird im wesentlichen Bezug auf die Behandlung von Trägern für Wafer Bezug genommen. Die erfindungsgemäße Vorrichtung kann aber für jegliche scheibenförmige Gegenstände verwendet werden, insbesondere, wenn deren Behandlung eine hohe Reinheit der Hilfsmittel erfordert.

Die erfindungsgemäße Vorrichtung vereinigt die Prozeßeinheiten des Reinigens und Speicherns der Träger sowie das Sortieren der scheibenförmigen Gegenstände in einem Zusammenschluß, einem sogenannten Cluster. Dieser Zusammenschluß wird durch die gemeinsame Regelung der Einheiten betrieben. Darüberhinaus ist durch die erfindungsgemäße Ausführung der Raumbedarf für die gesamte Vorrichtung gering.

Zu den Vorteilen, Wirkungen, Effekten sowie der Funktionsweise der erfindungsgemäßen Vorrichtung wird ebenfalls auf die nachfolgenden Ausführungen zum erfindungsgemäßen Verfahren vollinhaltlich Bezug genommen und hiermit verwiesen.

Die wesentlichen Vorteile einer solchen Vorrichtung ist daher zunächst die Reduzierung von sogenannten "Footprints". Ein "Footprint" stellt den Flächenbedarf einer Ausrüstung in einem Reinraum dar, wobei der Flächenbedarf entweder mit oder ohne die erforderlichen Serviceflächen ermittelt wird. Durch die erfindungsgemäße Vorrichtung wird der Bedarf an Reinraumfläche reduziert, da die Transportwege zwischen den einzelnen Bestandteilen der Vorrichtung aufgrund der internen Verknüpfung entfallen beziehungsweise reduziert werden.

Weiterhin wird eine Reduzierung der Zeit pro Durchlauf-Zyklus, insbesondere Zeiten der Unproduktivität für die Waferbearbeitung, um etwa das Vier- bis Achtfache pro behandeltem Wafer erreicht. Schließlich ist auch die Reduzierung der benötigten Transportbewegungen bei der erfindungsgemäßen Vorrichtung von Vorteil.

Wird ein Träger, der einen oder mehrere scheibenförmige Gegenstände, insbesondere Wafer enthält, der Vorrichtung zugeführt, so können diesem die scheibenförmigen Gegenstände über die Sortiereinheit entnommen und einem anderen Träger zugeführt werden. Der so entleerte Träger kann dann der Reinigungseinheit zugeführt werden. Nach der Reinigung wird der Träger dem internen Speicher zugeführt, wo er für eine erneute Beschickung zur Verfügung steht. Der mit den Gegenständen des geleerten Trägers bestückte Träger kann von der Vorrichtung durch Transporteinheiten weiteren Bearbeitungseinheiten zugeführt werden. Der Transport der Träger innerhalb der Vorrichtung, z.B. von der Reinigungseinheit zum internen Speicher erfolgt über automatisierte Transportsysteme. Die Transportsysteme werden von der gemeinsamen Regelung der Vorrichtung gesteuert und somit die Präsenz eines Trägers an der Stelle in der Vorrichtung gewährleistet, an der er benötigt wird, z.B. an der Sortiereinrichtung zur Aufnahme von Gegenständen aus einem zu leerenden Träger.

Bevorzugte Ausführungsformen der erfindungsgemäßen Vorrichtung ergeben sich aus den Unteransprüchen.

Vorteilhaft kann die Vorrichtung weiterhin mindestens eine Vermessungseinheit für die Träger aufweisen. Die Vermessung der Träger auf die Einhaltung der notwendigen Toleranzen kann somit in den Cluster einbezogen werden. Vorzugsweise wird die Vermessung des Trägers unmittelbar nach der Reinigung durchgeführt. Auf diese Weise kann der Träger dem Speicher zugeführt werden, von wo der gereinigte und vermessene Träger dann unmittelbar über die Sortiereinheit mit scheibenförmigen Gegenständen beladen und dem nächsten Verfahrensschritt zugeführt werden kann. Diese zusätzliche Einheit in dem Cluster vermeidet somit ein erneutes Entleeren des Trägers für Vermessungszwecke zu einem späteren Zeitpunkt.

Die Vorrichtung weist mindestens eine Ladeöffnung (auch "Loadport" genannt) zum Zuführen, bzw. Abführen der Träger auf. Vorzugsweise sind zwei Ladeöffnungen vorgesehen, wobei die eine der Zuführung von Trägern zu der Vorrichtung und die andere der Abführung von Trägern dient. Diese Ladeöffnungen sind insbesondere für die Verwendung für Waferträger, vorzugsweise ensprechend dem SEMI Standard E 15.1 ausgeführt. Gemäß diesem Standard ist die Ladeöffnung so ausgeführt, daß durch diese eine Schnittstelle zwischen der Vorrichtung und automatisierten oder manuellen Transportsystemen für Waferträger geschaffen wird.

Die Sortiereinheit weist vorzugsweise mindestens zwei mechanische Schnittstellen zum Zuführen bzw. Abführen von scheibenförmigen Gegenständen auf. Durch diese Schnittstellen können zum einen die scheibenförmigen Gegenstände von einem der. Vorrichtung zugeführten Träger entnommen werden und zum anderen einem vorbestimmten Träger, der dem Speicher entnommen wurde, zugeführt werden. Durch das Vorsehen von mindestens zwei Schnittstellen ist somit eine Zwischenlagerung der scheibenförmigen Gegenstände in der Sortiereinheit nicht notwendig.

Die mechanischen Schnittstellen sind insbesondere bei Verwendung der Vorrichtung für Waferträger entsprechend dem SEMI Standard E 62 ausgeführt. Dieser Standard beschreibt sogenannte Front-Opening-Interface-Mechanical-Standard (FIMS) Schnittstellen bzw. Ladeöffnungen durch die der Transfer von Wafern zwischen einer Bearbeitungseinheit und einem Transportbehälter ermöglicht wird, wobei der Transportbehälter die Form einer Box besitzt und an seiner Frontseite eine Tür aufweist. Diese Behälter, in denen die Waferträger als herausnehmbare oder fest montierte Magazine ausgeführt seien können, werden als Front-Opening-Unified-Pods (FOUPs) bezeichnet und sind in SEMI Standard E 47.1 beschrieben. Die Reinigungseinheit kann auch so ausgebildet sein, daß bei Verwendung solcher Boxen auch diese gereinigt werden.

Gemäß einer bevorzugten Ausführungsform umfaßt die Vorrichtung mindestens eine Datenerkennungs- und mindestens eine Datenzuweisungseinheit für die Träger.

Durch diese Datenerkennungs- und Datenzuweisungseinheit wird die gemeinsame Regelung der Vorrichtung (des Clusters) verbessert.

Insbesondere in der Halbleitertechnik sind Träger für scheibenförmige Gegenstände so ausgestaltet, daß diesem Daten zugeordnet werden können. Dies erfolgt vorzugsweise über Sensoren im Boden des Trägers bzw. der Box in der der Träger gehalten wird. Die Anordnung der Sensoren ist beispielsweise in SEMI Standard E 1.9 beschrieben. Neben den Sensoren sind vorzugsweise auch kinematische Verbindungen am Boden der Box angeordnet.

Über die Sensoren können Informationen bezüglich der in dem Träger gehaltenen Wafer an entsprechende Sensoren, z.B. in der Ladeöffnung der Vorrichtung gegeben werden. Durch Vorsehen einer Datenerkennungs- und Datenzuweisungseinheit in der erfindungsgemäßen Vorrichtung können die Daten der Träger, die der Vorrichtung zugeführt werden, erkannt werden. Die Vorrichtung erhält Informationen über die Anzahl der in dem Träger gehaltenen Wafer und gegebenenfalls zusätzliche Informationen über die einzelnen Wafer. Nachdem die Datenerkennungseinrichtung an der Ladeöffnung diese Informationen empfangen hat, kann gemäß diesen Daten ein Träger im Speicher lokalisiert werden, in den die Wafer des ankommenden Trägers umgeladen werden können. Nachdem der Umladevorgang von der Sortiereinheit ausgeführt wurde, werden dem neuen Träger über die Datenzuweisungseinheit die relevanten Informationen in Form von Daten zugewiesen. Dieser beschickte und mit den relevaten Daten versehene Träger kann dann weiteren Bearbeitungsvorrichtungen zugeführt werden.

In einer weiterhin bevorzugten Ausführungsform umfaßt die Vorrichtung mindestens eine Identifizierungs- und Wegweisungseinheit für die scheibenförmigen Gegenstände.

Durch diese Einheit, die vorzugsweise der Sortiereinheit zugeordnet ist, wird ein von einem Träger entnommener Gegenstand identifiziert und ihm ein bestimmter Transferweg zugewiesen. Dieser Weg bestimmt die Position, die der Gegenstand in dem neuen Träger, in den er transferiert wird einnimmt.

Vorzugsweise kann die Vorrichtung einen Öffnungsmechanismus für Boxen, in denen die Träger der Gegenstände gehalten sind, aufweisen. Die Träger werden vorzugsweise in Boxen transportiert, um eine Beschädigung der Gegenstände und eine Verschmutzung der Gegenstände durch Umwelteinflüße zu verhindern. Auf dem Gebiet der Halbleitertechnik werden insbesondere FOUPs eingesetzt. Diese weisen an ihrer Frontseite eine Türe auf, die den Zugriff zu einzelnen Wafern ermöglicht. Das Öffnen der Boxen ist in der erfindungsgemäßen Vorrichtung an der Schnittstelle zu der Sortiereinheit notwendig, wo die Wafer einem Träger entnommen und einem anderen Träger zugeführt werden. Die Öffnung der Türe kann über Saugmechanismen, z.B. durch Saugnäpfe, aber auch durch mechanisch oder hydraulisch gesteuerte Hebe- bzw. Greifmechanismen erfolgen.

Die Reinigungseinheit kann zur Reinigung jeweils eines Trägers ausgelegt sein, oder die gleichzeitige Reinigung mehrerer Träger erlauben. Die Reinigung kann mit entionisiertem Wasser oder auf Lösungsmittel-Basis erfolgen. Vorzugsweise unterstützt die Transportvorrichtung für die Träger auch die Reinigungeinheit, so daß ein zusätzlicher Transfervorgang von der Transportvorrichtung, die für den Transport der Träger von der Ladeöffnung zu der Sortiereinheit und von dort zur Reinigungseinheit, sowie von der Reinigungseinheit zum Speicher und von dort zur Sortiereinheit bis hin zur Entladeöffnung zuständig ist, auf eine Transportvorrichtung in der Reinigungseinheit entfällt.

Weiterhin ist ein Verfahren zum Behandeln und Aufbewahren von Trägern für scheibenförmige Gegenstände, bei dem eine erfindungsgemäße Vorrichtung verwendet wird, Gegenstand der Erfindung.

Das Verfahren weist erfindungsgemäß folgende Schritte auf:
a) Ein Träger, der einen oder mehrere scheibenförmige Gegenstände enthält, wird der Vorrichtung zugeführt;
b) die scheibenförmigen Gegenstände werden über eine Sortiereinheit entnommen und einem anderen Träger zugeführt;
c) der entleerte Träger wird einer Reinigungseinheit zugeführt und dort gereinigt;
d) anschließend wird der gereinigte Träger einem internen Speicher zugeführt, wo er für eine erneute Beschickung zur Verfügung steht.

Vorzugsweise wird der Träger nach oder während dem Schritt c) vermessen.

Vorteilhaft wird der gemäß Schritt b) mit scheibenförmigen Gegenständen bestückte Träger von der Vorrichtung anderen Bearbeitungseinheiten zugeführt.

Zu den Vorteilen, Wirkungen, Effekten sowie der Funktionsweise des erfindungsgemäßen Verfahrens wird ebenfalls auf die vorstehenden Ausführungen zur erfindungsgemäßen Vorrichtung vollinhaltlich Bezug genommen und hiermit verwiesen.

Gemäß einer vorteilhaften Ausführungsform des Verfahrens kann ein Träger durch geeignete automatisierte oder manuelle Transportsysteme zu einer Ladeöffnung in der erfindungsgemäßen Vorrichtung gebracht werden. Dort können durch ein geeignetes Datenerkennungssystem die dem Träger zugeordneten Daten der gemeinsamen Regelung zugeführt werden. Aufgrund dieser Daten wird ein Träger aus der Speichereinheit oder unmittelbar von der Reinigungs- oder gegebenenfalls von der Vermessungseinheit zu einer mechanischen Schnittstelle der Sortiereinheit transportiert. Gleichzeitig oder vorher wird der der Vorrichtung zugeführte Träger zu einer weiteren mechanischen Schnittstelle der Sortiereinheit transportiert. An der Sortiereinheit wird durch den Öffnungsmechanismus die Türe, die an der Frontseite der Box, die den Träger hält geöffnet und somit einer in der Sortiereinheit vorgesehene Umladevorrichtung Zugriff zu den einzelnen Gegenständen des ankommenden Trägers ermöglicht. Von der Umladevorrichtung wird jeder Gegenstand zu dem mittlerweile an der weiteren mechanischen Schnittstelle bereit stehenden Träger transferiert. Dem somit beladenen Träger werden die Daten der Gegenstände die er aufgenommen hat über die gemeinsame Regelung zugeordnet und der so beschickte Träger wird mittels einer Transportvorrichtung zu einer Entladeöffnung der Vorrichtung gebracht, wo er von automatisierten oder manuellen Transportsystemen aufgenommen und weiteren Bearbeitungsvorrichtungen zugeführt werden kann.

Der Träger, dem die Gegenstände in der Vorrichtung entnommen wurden, kann mittels des Transportsystems innerhalb der Vorrichtung zu der Reinigungseinheit gebracht werden. Dort wird der Träger einer Reinigung unterzogen und gegebenenfalls anschließend vermessen. Befindet sich der Träger innerhalb einer weiter oben beschriebenen Box (Pod), kann auch diese von der Reinigungseinheit einer Reinigung unterzogen werden. Anschließend wird der Träger entweder unmittelbar der mechanischen Schnittstelle der Sortiereinheit zugeführt, an der er mit Gegenständen eines anderen Trägers beschickt wird, oder der Träger wird dem Speicher zugeführt, wo er verbleibt, bis er von dem Transportsystem zu der Schnittstelle der Sortiereinheit gebracht wird.

Bevorzugt wird eine Vorrichtung und/oder ein Verfahren zum Behandeln und Aufbewahren von Trägern für scheibenförmige Gegenstände verwendet, bei denen es sich um Wafer, beispielsweise 300mm Wafer handelt.

Bei der Behandlung von Wafern ist ein Verfahren, bei dem mehrere Behandlungsschritte für Hilfsmaterial, in diesem Fall die Reinigung, Aufbewahrung und Beschickung, sowie gegebenenfalls die Vermessung von Trägern, insbesondere FOUPs, in einem Cluster zusammengefaßt werden können von besonderer Bedeutung. Durch einen solchen Logistik-Cluster kann zum einen die Behandlungszeit der Träger, die eine Fehlzeit für den Durchsatz der Waferbearbeitung darstellt, minimiert und zum anderen die Anzahl der Prozeßschritte für diesen Behandlungsvorgang minimiert werden. Insbesondere ist bei der Forderung, daß Wafer in einem bestimmten gereinigten Träger gehalten werden sollen, lediglich ein einziger Umladevorgang notwendig. Dadurch wird es zum Beispiel möglich, innerhalb des Reinraums die Reinigungs-, Sortiereinheit und den Speicher vorzsusehen, wodurch z.B. Kupferträger in einem internen Prozeßverlauf der Vorrichtung gehalten werden können.

Vorzugsweise umfaßt der Cluster einen internen Speicher, einen sogenannten "Equipment Front End Module" (EFEM) als Bestandteil der Ladeöffnung gemäß SEMI Standard E15.1 und interne Wafer-Ladeöffnungen, kinematische Verbindungen, Sensoren, Träger ID-Erkennungseinheiten, PI/O (dieser beinhaltet eine Kommunikationsschnittstelle, über die bestimmte Informationen zur Steuerung des Transfers des Trägers vom/zum Loadport ausgetauscht werden), Öffnungsmechanismen für Boxen, einen Speicher und Transportvorrichtungen für Träger sowie Wafer-Umladevorrichtungen unter Miniumgebungs-Bedingungen, ID-Erkennungseinheiten und Wegweisereinheiten für die Wafer.

Die Anforderungen an solche Miniumgebungs-Bedingungen sind beispielsweise in dem Dokument "Integrated Minienvironment Design Best Modes Practices" , International SEMATECH, Technology Transfer '99033693A-ENG, SEMATECH Technology Transfer, 2706 Montopolis Drive, Austin, TX 78741, USA, http://www.sematech.org beschrieben.

Der Cluster kann mit dem Hostsystem verbunden werden. Die Größe des internen Speichers hängt von dem benötigten Reinigungs- und Vermessungszyklus ab.

Die Erfindung wird im Folgenden anhand der beiliegenden Zeichnungen erklärt, wobei diese lediglich Ausführungsbeispiele darstellen und in keiner Weise den Gegenstand der Erfindung einschränken. Es zeigen:
Fig. 1: eine schematische Darstellung einer Ausführungsform der erfindungsgemäßen Vorrichtung bei der die Be- und Entladeöffnungen an einer Seite angeordnet sind;
Fig. 2: eine schematische Darstellung einer Ausführungsform der erfindungsgemäßen Vorrichtung bei der die Be- und Entla deöffnungen an aneinander anliegenden Seiten angeordnet sind; und
Fig. 3: eine schematische Darstellung einer Ausführungsform der erfindungsgemäßen Vorrichtung bei der die Be- und Entladeöffnungen an gegenüberliegenden Seiten angeordnet sind.

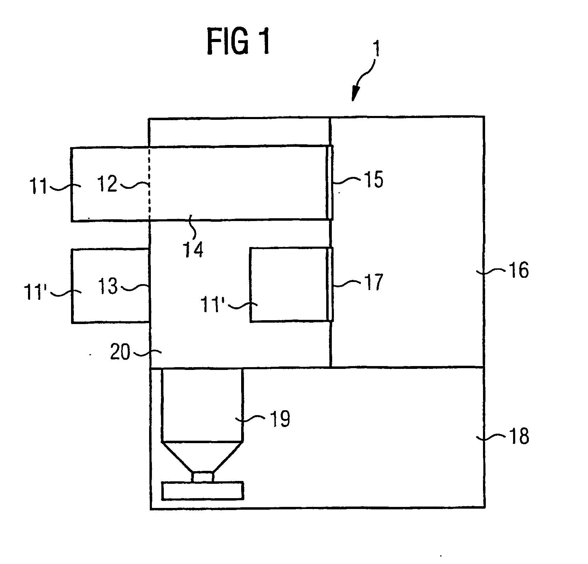

In Figur 1 ist eine Vorrichtung 1 gemäß einer Ansführungsform der vorliegenden Erfindung dargestellt, die eine integrale Baueinheit bildet und die auch als "Cluster" bezeichnet wird. An der linken Seite sind zwei Ladeöffnungen 12, 13 vorgesehen, wobei die eine Öffnung 12 zur Zuführung von Trägern 11 zu der Vorrichtung 1 und die andere Öffnung 13 zum Abführen von Trägern 11' von der Vorrichtung 1 dient. In der dargestellten Ausführungsform ist die Ladeöffnung 12 mit einem verlängerten Zuführungsbereich 14 versehen. Ein solcher verlängerter Zuführungsbereich 14 kann zur Aufnahme mehrerer Träger 11 dienen. Am Ende des Zuführungsbereiches 14 ist eine mechanische Schnittstelle 15 vorgesehen. Diese mechanische Schnittstelle 15 dient der Verbindung zwischen dem Zuführungsbereich 14 und einer Sortiereinheit 16. Die mechanische Schnittstelle 15 ist vorzugsweise als FIMS gemäß dem SEMI Standard E 62 ausgestaltet. Sie erlaubt den Zugriff einer Umladevorrichtung (nicht dargestellt) der Sortiereinheit 16 zu einzelnen Gegenständen, die in dem Träger 11 gehalten sind. Ist der Träger 11 gemäß dem SEMI Standard E 47.1 ausgestaltet, weist er also insbesondere eine Box auf, in der der Träger 11 gehalten wird, so kann die mechanische Schnittstelle 15 zusätzlich einen Öffnungsmechanismus für die Türe der Box aufweisen. Neben der mechanische Schnittstelle 15 ist eine weitere mechanische Schnittstelle 17 vorgesehen, durch die die Umladevorrichtung der Sortiereinheit 16 einem weiteren Träger 11' die dem Träger 11 entnommenen Gegenstände zuführen kann. Auch diese mechanische Schnittstelle 17 ist vorzugsweise als FIMS gemäß SEMI Standard E 62 ausgestaltet. Benachbart zu der Sortiereinheit 16 ist eine Reinigungseinheit 18 vorgesehen. Diese Reinigungseinheit 18 kann zur Reinigung von einzelnen oder auch mehreren Trägern 11 gleichzeitig ausgelegt sein.

Weiterhin ist in der Vorrichtung 1 eine Vermessungseinheit 19 vorgesehen. Diese ist in Figur 1 als Bestandteil der Reinigungseinheit 18 dargestellt. Sie kann aber auch als räumlich getrennte Einheit innerhalb der Vorrichtung 1 vorgesehen sein. Angrenzend zu der mechanische Schnittstelle 17 ist ein Speicher 20 vorgesehen. Dieser Speicher kann von vertikaler oder horizontaler Form sein. Die Träger 11', die darin nach der Reinigung und Vermessung aufgenommen werden können, somit nebeneinander oder aufeinander angeordnet werden.

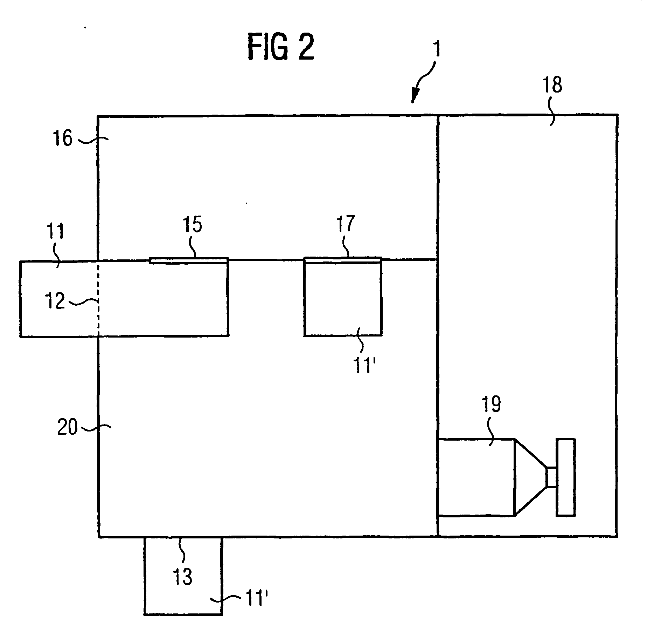

In Figur 2 ist eine weitere Ausführungsform der erfindungsgemäßen Vorrichtung 1 dargestellt. Diese Ausführungsform entspricht im wesentlichen der in Figur 1 gezeigten Vorrichtung. Bei der in Figur 2 gezeigten Ausführungsform ist die Ladeöffnung 13 zum Abführen von beschickten Trägern 11' an der Seite angeordnet, die an die Seite angrenzt, an der die Ladeöffnung 12 angeordnet ist. Durch diese Anordnung der Ladeöffnungen 12, 13 wird zusätzlicher Raum für den Speicher 20 geschaffen.

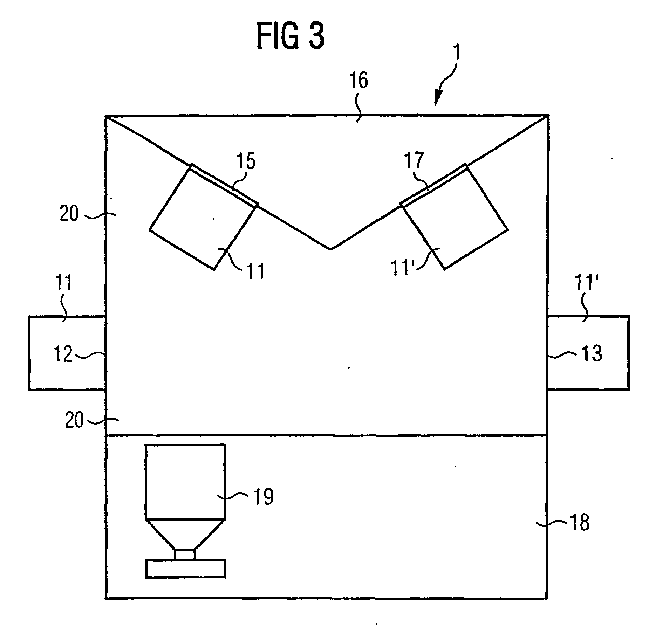

In der in Figur 3 gezeigten Ausführungsform sind die Ladeöffnungen 12, 13 an gegenüberliegenden Seiten der Vorrichtung 1 angeordnet. Die Sortiereinheit 16 ist so angeordnet, daß deren mechanische Schnittstellen 15, 17 unter einem Winkel zu der Ladeöffnung 12 bzw. 13 stehen. Die Sortiereinrichtung 16 ragt bei der in Figur 3 dargestellten Ausführungsform als eine Spitze in den Speicher 20 hinein und die Reinigungseinheit 18 ist an der gegenüberliegenden Seite des Speichers 20 angeordnet. Durch diese Anordnung wird der Raum, in dem die Träger transportiert werden können, vergrößert und darüber hinaus kann diese Vorrichtung bezüglich des Zu- und Abführungsvorganges umgekehrt werden. Die Ladeöffnung 13 kann in dieser Ausführungsform auch als Zuführungsöffnung für beladene Träger verwendet werden und die Ladeöffnung 12 als Abführungsöffnung. Auch bei Reversion des Verfahrensablaufes werden die von den Trägern 11, 11' zurückzulegenden Wege nicht verlängert.

Die in den Figuren dargestellten Ausführungsformen werden bevorzugt für die Beschickung, Aufbewahrung und Reinigung sowie gegebenenfalls Vermessung von Trägern für Wafer, insbesondere von Trägern, die als FOUPs für 300mm Wafer ausgestaltet sind, verwendet.

Die in der erfindungsgemäßen Vorrichtung eingesetzten Transportsysteme für den Transport der Träger innerhalb der Vorrichtung können als Roboterarme, z.B. Greifarme, aber auch als Förderbänder oder dergleichen ausgestaltet sein.

Die in der Sortiereinheit vorgesehene Umladevorrichtung kann beispielsweise als Roboterarm ausgestaltet sein. Vorzugsweise sind die mechanischen Schnittstellen der Sortiereinheit so angeordnet, daß diese von der Umladevorrichtung, z.B. durch Rotation erreicht werden können, ohne einen zusätzlichen Bewegungsvorgang, z.B. Verschieben der Umladevorrichtung erforderlich zu machen.

Vorzugsweise kann eine Zwischenlagerung von Gegenständen in der Sortiereinheit vorgesehen werden. Durch eine solche Zwischenlagerung kann einem Mangel an gereinigten Trägern Rechnung getragen werden.

## Patentansprüche

1. Vorrichtung (1) zum Behandeln, Lagern und Beschicken von Trägern für scheibenförmige Gegenstände, wie Halbleiterscheiben oder CDs, die mindestens eine Reinigungseinheit (18) und mindestens einen Speicher (20) für Träger (11, 11') für die scheibenförmigen Gegenstände sowie mindestens eine Sortiereinheit (16) für die scheibenförmigen Gegenstände aufweist, wobei die Reinigungseinheit (18), der Speicher (20) und die Sortiervorrichtung (16) integrale Bestandteile der Vorrichtung (1) sind und durch eine gemeinsame Regelung betrieben werden.

2. Vorrichtung (1) gemäß Anspruch 1,
**dadurch gekennzeichnet,**
**daß** diese weiterhin mindestens eine Vermessungseinheit (19) für die Träger aufweist.

3. Vorrichtung (1) gemäß einem der Ansprüche 1 oder 2,
**dadurch gekennzeichnet,**
**daß** diese mindestens eine Ladeöffnung (12, 13) zum Zuführen, bzw. Abführen der Träger (11, 11') aufweist.

4. Vorrichtung (1) gemäß einem der Ansprüche 1 bis 3,
**dadurch gekennzeichnet,**
**daß** die Sortiereinheit (16) mindestens zwei mechanische Schnittstellen (15, 17) zum Zuführen bzw. Abführen von scheibenförmigen Gegenständen aufweist.

5. Vorrichtung gemäß einem der Ansprüche 1 bis 4,
**dadurch gekennzeichnet,**
**daß** diese mindestens eine Datenerkennungs- und mindestens eine Datenzuweisungseinheit für die Träger (11, 11') aufweist.

6. Vorrichtung gemäß einem der Ansprüche 1 bis 5,
**dadurch gekennzeichnet,**
**daß** die Vorrichtung (1) mindestens eine Identifizierungs- und Wegweisungseinheit für die scheibenförmigen Gegenstände aufweist.

7. Vorrichtung gemäß einem der Ansprüche 1 bis 6,
**dadurch gekennzeichnet,**
**daß** diese einen Öffnungsmechanismus für Boxen, in denen die Träger (11, 11') der Gegenstände gehalten sind, aufweist.

8. Vorrichtung gemäß einem der Ansprüche 1 bis 7,
**dadurch gekennzeichnet,**
**daß** die Reinigungseinheit (18) zur Reinigung jeweils eines Trägers (11) oder zur gleichzeitigen Reinigung mehrerer Träger (11) ausgelegt ist.

9. Verfahren zum Behandeln und Aufbewahren von Trägern für scheibenförmige Gegenstände, bei dem eine Vorrichtung gemäß einem der Ansprüche 1 bis 8 mit einem internen Speicher verwendet wird, mit folgenden Schritten:
a) Ein Träger, der einen oder mehrere scheibenförmige Gegenstände enthält, wird der Vorrichtung zugeführt;
b) die scheibenförmigen Gegenstände werden über die Sortiereinheit entnommen und einem anderen Träger zugeführt;
c) der entleerte Träger wird der Reinigungseinheit zugeführt und dort gereinigt;
d) anschließend wird der gereinigte Träger dem internen Speicher zugeführt, wo er für eine erneute Beschickung zur Verfügung steht. '

10. Verfahren nach Anspruch 9,
**dadurch gekennzeichnet,**
**daß** der Träger nach oder während Schritt c) vermessen wird.

11. Verfahren nach Anspruch 9 oder 10,
**dadurch gekennzeichnet,**
**daß** der gemäß Schritt b) mit scheibenförmigen Gegenständen bestückte Träger von einer Vorrichtung gemäß einem der Ansprudre 1-8 anderen Bearbeitungseinheiten zugeführt wird.

12. Verwendung einer Vorrichtung nach einem der Ansprüche 1 bis 8 und/oder eines Verfahrens nach einem der Ansprüche 9 bis 11 zum Behandeln, Lagern und Beschicken von Trägern für Wafer, insbesondere 300mm Wafer.

## Claims

1. Apparatus (1) for handling, storing and charging carriers for disc-shaped items, such as semiconductor wafers or CDs, which has at least one cleaning unit (18) and at least one store (20) for carriers (11, 11') for the disc-shaped items and also at least one sorting unit (16) for the disc-shaped items, with the cleaning unit (18), the store (20) and the sorting apparatus (16) being integral component parts of the apparatus (1) and being operated by a common automatic control.

2. Apparatus (1) according to Claim 1, **characterized in that** it also has at least one measuring unit (19) for the carriers.

3. Apparatus (1) according to either of Claims 1 and 2, **characterized in that** it has at least one loading opening (12, 13) for respectively feeding and carrying away the carriers (11, 11').

4. Apparatus (1) according to one of Claims 1 to 3, **characterized in that** the sorting unit (16) has at least two mechanical interfaces (15, 17) for respectively feeding and carrying away disc-shaped items.

5. Apparatus according to one of Claims 1 to 4,
**characterized in that** it has at least one data recognition unit and at least one data allocation unit for the carriers (11, 11').

6. Apparatus according to one of Claims 1 to 5, **characterized in that** the apparatus (1) has at least one identification and path-indicating unit for the disc-shaped items.

7. Apparatus according to one of Claims 1 to 6, **characterized in that** it has an opening mechanism for boxes in which the carriers (11, 11') of the items are held.

8. Apparatus according to one of Claims 1 to 7,
**characterized in that** the cleaning unit (18) is designed for cleaning one carrier (11) at a time or for cleaning a number of carriers (11) simultaneously.

9. Method for handling and storing carriers for disc-shaped items, in which an apparatus according to one of Claims 1 to 8 having an internal store is used, with the following steps:
a) a carrier which contains one or more disc-shaped items is fed to the apparatus;
b) the disc-shaped items are removed and fed to another carrier by means of the sorting unit;
c) the emptied carrier is fed to the cleaning unit and cleaned there;
d) subsequently, the cleaned carrier is fed to the internal store, where it is available for renewed charging.

10. Method according to Claim 9, **characterized in that** the carrier is measured after or during step c).

11. Method according to Claim 9 or 10, **characterized in that** the carrier fitted with disc-shaped items according to step b) is fed by an apparatus according to one of Claims 1 - 8 to other processing units.

12. Use of an apparatus according to one of Claims 1 to 8 and/or of a method according to one of Claims 9 to 11 for handling, storing and charging carriers for wafers, in particular 300 mm wafers.

## Revendications

1. Installation (1) de traitement, d'emmagasinage et de chargement de supports pour des objets en forme de disque, comme des tranches de semi-conducteurs ou des CD, qui comporte au moins une unité (18) de nettoyage et au moins un accumulateur (20) de supports (11, 11') pour les objets en forme de disque, ainsi qu'au moins une unité (16) de triage des objets en forme de disque, l'unité (18) de nettoyage, l'accumulateur (20) et le dispositif (16) de triage faisant partie intégrante de l'installation (1) et fonctionnant au moyen d'une régulation commune.

2. Installation (1) suivant la revendication 1,
**caractérisée**
**en ce qu'**elle comporte, en outre, au moins une unité (19) de mesure des supports.

3. Installation (1) suivant l'une des revendications 1 ou 2,
**caractérisée**
**en ce qu'**elle comporte au moins une ouverture (12, 13) de charge pour faire entrer ou pour faire sortir les supports (11, 11').

4. Installation (1) suivant l'une des revendications 1 à 3,
**caractérisée**
**en ce que** l'unité (16) de triage comporte au moins deux interfaces (15, 17) mécaniques pour faire entrer ou pour faire sortir des objets en forme de disque.

5. Installation (1) suivant l'une des revendications 1 à 4,
**caractérisée**
**en ce qu'**elle comporte au moins une unité de reconnaissance de données et au moins une unité d'attribution de données pour les supports (11, 11').

6. Installation (1) suivant l'une des revendications 1 à 5,
**caractérisée**
**en ce que** l'installation (1) comporte au moins une unité d'identification et d'indication de trajet pour les objets en forme de disque.

7. Installation (1) suivant l'une des revendications 1 à 6,
**caractérisée**
**en ce qu'**elle comporte un mécanisme d'ouverture pour des boîtes, dans lesquelles les supports (11, 11') des objets sont contenus.

8. Installation (1) suivant l'une des revendications 1 à 7,
**caractérisée**
**en que** l'unité (18) de nettoyage est conçue pour le nettoyage de, respectivement, un support (11) ou pour le nettoyage de plusieurs supports (11) en même temps.

9. Procédé de traitement et de conservation de supports pour des objets en forme de disque, dans lequel on utilise une installation suivant l'une des revendications 1 à 8 ayant un accumulateur interne, comprenant les stades suivants :
a) on apporte à l'installation un support qui contient un ou plusieurs objets en forme de disque ;
b) on prélève les objets en forme de disque par l'unité de triage et on les apporte à un autre support ;
c) on apporte le support vidé à l'unité de nettoyage et on l'y nettoie ;
d) ensuite, on apporte le support nettoyé à l'accumulateur interne où il est disponible pour un nouveau chargement.

10. Procédé suivant la revendication 9,
**caractérisé**
**en ce que** l'on mesure le support après ou pendant le stade c).

11. Procédé suivant la revendication 9 ou 10,
**caractérisé**
**en ce que** l'on apporte le support équipé des objets en forme de disque suivant le stade b) d'une installation suivant l'une des revendications 1 à 8 à d'autres unités d'usinage.

12. Utilisation d'une installation suivant l'une des revendications 1 à 8 et/ou d'un procédé suivant l'une des revendications 9 à 11 pour le traitement, l'emmagasinage et le chargement de supports pour des tranches, notamment pour des tranches de 300 mm.
